# FASCICULE DE BREVET EUROPEEN

(11) **EP 1 892 766 B1**
(45) Date de publication et mention de la délivrance du brevet: **27.09.2017**
(21) Numéro de dépôt: 07114820.9
(22) Date de dépôt: 23.08.2007
(51) Int. Cl.: H01L 29/786, H01L 21/335, H01L 29/775, H01L 29/06, H01L 29/161, H01L 29/10, B82Y 10/00

(54) **Procédé de réalisation d'un dispositif comportant une structure dotée d'un ou plusieurs micro-fils ou nano-fils à base d'un composé de Si et de Ge, par condensation germanium.**
Herstellungsverfahren einer Vorrichtung mit einer Struktur mit einem oder einer Mehrzahl von Mikro- und Nanodrähten auf der Basis von Si und Ge mittels Germanium-Kondensation
Method for manufacturing a device having a structure with one or a plurality of Si and Ge-based micro or nanowires, using germanium condensation

(30) Priorité: 25.08.2006 FR 0653471
(43) Date de publication de la demande: 27.02.2008
(73) Titulaire: Commissariat à l'Énergie Atomique et aux Énergies Alternatives, 75015 Paris (FR)
(72) Inventeur: Damlencourt, Jean-Francois, 38120 Saint-Égrève (FR)
(74) Mandataire: Ahner, Philippe

(56) Documents cités:
- US-A1- 2004 166 642
- US-B1- 7 015 078
- LIOW TSUNG-YANG ET AL: "Investigation of silicon-germanium fins fabricated using germanium condensation on vertical compliant structures" APPLIED PHYSICS LETTERS, AIP, AMERICAN INSTITUTE OF PHYSICS, MELVILLE, NY, US, vol. 87, no. 26, 19 décembre 2005 (2005-12-19), pages 262104-1-262104-3, XP012077069 ISSN: 0003-6951
- TEZUKA T ET AL: "HIGH-MOBILITY STRAINED SIGE-ON-INSULATOR PMOSFETS WITH GE-RICH SURFACE CHANNELS FABRICATED BY LOCAL CONDENSATION TECHNIQUE" IEEE ELECTRON DEVICE LETTERS, IEEE SERVICE CENTER, NEW YORK, NY, US, vol. 26, no. 4, avril 2005 (2005-04), pages 243-245, XP001230451 ISSN: 0741-3106
- LIU J. L.: "Fabrication of silicon quantum wires by anisotropic wet chemical etching and thermal oxidation" JOURNAL OF VACUUM SCIENCE AND TECHNOLOGY - B, vol. 13, no. 5, août 1995 (1995-08), - septembre 1995 (1995-09) pages 2137-2138, XP002426481

## Description

### DOMAINE TECHNIQUE

L'invention concerne un procédé de réalisation d'un dispositif microélectronique amélioré dans lequel des nanofils semi-conducteurs à base de Si_{1-z}Ge_{z} (avec z > 0) sont formés, à l'aide d'au moins une première étape d'oxydation thermique d'une ou plusieurs zones semi-conductrices à base d'un composé de silicium et de germanium, et d'au moins une étape d'oxydation thermique latérale d'une ou plusieurs zones semi-conductrices à base d'un autre composé de silicium et de germanium résultant de la première oxydation.

La présente invention se rapporte plus particulièrement aux transistors, et a pour but de présenter un transistor doté en particulier d'une structure de canal ou multi-canaux sous forme d'un ou plusieurs nanofil (s) à base de Si_{1-z}Ge_{z}, reliant une zone semi-conductrice destinée à jouer le rôle d'une région de source et une autre zone semi-conductrice destinée à jouer le rôle d'une région de drain. Une telle structure peut s'adapter à des structures de grille dites « enrobantes ». Il se pose le problème de trouver une nouveau procédé de réalisation d'un dispositif microélectronique comportant une structure dotée d'un ou plusieurs fils semi-conducteurs à base de germanium ou d'un composé de Si et de Ge ayant une forte teneur en Germanium.

### ART ANTÉRIEUR

Une structure de canal à nanofil(s) semi-conducteur(s) et grille enrobante permet d'obtenir un transistor de dimensions réduites et dans lequel le contrôle électrostatique de la charge d'inversion est amélioré. Les règles de dimensionnement des circuits intégrés et les limitations physiques de fonctionnement des transistors nanométriques (effets de canal court, courant tunnel dans l'isolant) ont conduit de plus en plus à réaliser des transistors dotés d'une double ou triple grille, tels que les transistors « Finfet » et tri-gate, et dont la structure de canal peut être sous forme d'un ou plusieurs barreaux semi-conducteurs ou fils semi-conducteurs disjoints.

Un procédé connu pour former des fils semi-conducteurs est la croissance par CVD (CVD pour « Chemical Vapor Deposition » ou dépôt chimique en phase vapeur). Un tel type de procédé permet d'obtenir une qualité cristalline et un contrôle du diamètre des fils supérieurs à ceux que l'on obtient par gravure. On peut réaliser ainsi des hétérojonctions de matériaux IV-IV et III-V, dans le sens de la croissance du fil, pour permettre de réaliser de nombreuses applications tant par l'utilisation de propriétés de transport que de propriétés ontiques. Cependant, avec un tel type de procédé, la maîtrise de la forme des fils et un positionnement précis de ces derniers sont difficiles à obtenir.

Un autre procédé de réalisation de fils semi-conducteurs, consiste à faire croître ces fils sur les flancs d'un empilement de couches minces. Cette approche nécessite, cependant, des techniques de lithographie, d'épitaxie sélective et gravure sélective isotrope complexes à mettre en oeuvre.

Par ailleurs, le germanium pur présentant une mobilité deux fois plus élevée pour les électrons et quatre fois plus élevée pour les trous que le silicium, on cherche de plus en plus à réaliser des dispositifs microélectroniques dotés de canaux à base de germanium ou d'un composé de silicium et de germanium dans lequel la teneur en germanium est importante. Un inconvénient des transistors dotés d'un canal formé dans un substrat à base de germanium, est le coût élevé du substrat. En outre, il est très difficile de réaliser par épitaxie des canaux en germanium ou en alliage de SiGe fortement enrichie en Ge présentant une bonne qualité cristalline. La réalisation de transistors en Ge requiert de nombreuses adaptations du fait de l'instabilité de l'oxyde de Germanium. A titre d'exemple, il est actuellement difficile de réaliser de bons contacts métalliques sur des zones sources et drains constituées d'un matériau SiGe avec une composition en Ge supérieure à 30 %.

Dans le document FR 0505701, un procédé de réalisation d'un dispositif de transistor doté d'une structure de canal enrichie en Germanium est décrite. Le procédé comprend : la réalisation sur un substrat d'un empilement de couches à base d'un composé de germanium et silicium, ayant entre elles des concentrations en germanium différentes, la délimitation par gravure dans ledit empilement d'une zone destinée à servir de zone de canal, l'oxydation thermique, superficielle et latérale, de la zone destinée à servir de zone de canal, de manière à former une zone de canal enrichie en germanium.

Le document de Liow Tsung et al. : « Investigation of Silicon-Germanium Fins Fabricated Using Germanium Condensation on Vertical Compliant Structures », Institute of Physics, Melville, NY, US, vol. 87, n°26., 19 décembre 2005, page 262104-1/4, divulgue un procédé de réalisation d'un dispositif microélectronique comportant une zone semi-conductrice à base de Si_{1-y}Ge_{y} (avec 0 < y ≤ 1), comprenant l'oxydation thermique d'un bloc semi-conducteur à base de Si₁₋ₓGeₓ (avec 0 < x < 1 et x < y).

Il se pose le problème de trouver un nouveau procédé de réalisation d'un dispositif microélectronique doté de fils semi-conducteurs à base de Si_{1-z}Ge_{z} ayant une concentration en Germanium élevée.

### EXPOSÉ DE L'INVENTION

La présente invention a pour but de remédier aux inconvénients mentionnés ci-dessus et de réaliser une structure de canal de forme « filaire » en Ge ou en alliage de silicium et de Ge de taille micro ou nanométrique sur isolant par condensation Germanium.

L'invention concerne en particulier un procédé de réalisation d'un dispositif microélectronique comportant un ou plusieurs fils semi-conducteurs à base de Si_{1-z}Ge_{z} (avec 0 < z ≤ 1), comprenant les étapes de :
a) oxydation thermique d'au moins une partie d'une couche semi-conductrice à base de Si₁₋ₓGeₓ (avec 0 < x < 1) reposant sur un substrat de type semi-conducteur sur isolant, de manière à former au moins une zone semi-conductrice à base de Si_{1-y}Ge_{y} (avec 0 < y < 1 et x < y),
b) oxydation thermique latérale des flancs d'un ou plusieurs blocs semi-conducteurs dits « de liaison » issus de ladite zone semi-conductrice à base de Si_{1-y}Ge_{y} et reliant un bloc semi-conducteur destiné à former une région de source de transistor et un autre bloc destiné à former une région de drain de transistor, de manière à réduire les blocs semi-conducteurs de liaison dans au moins une direction parallèle au plan principal du support et à former un ou plusieurs fils semi-conducteurs à base de Si_{1-z}Ge_{z} (avec 0 < y < 1 et y < z) reliant le bloc semi-conducteur destiné à former une région de source de transistor et l'autre bloc destiné à former une région de drain de transistor.

La présente invention concerne également un procédé de réalisation d'un dispositif microélectronique comportant un ou plusieurs fils semi-conducteurs à base de Si_{1-z}Ge_{z} (avec 0 < z ≤ 1), comprenant les étapes de :
a) oxydation thermique latérale des flancs d'un ou plusieurs blocs semi-conducteurs dits « de liaison » issus d'une couche semi-conductrice à base de Si₁₋ₓGeₓ (avec 0 < x < 1) reposant sur un substrat de type semi-conducteur sur isolant, et reliant un bloc semi-conducteur destiné à former une région de source de transistor et un autre bloc destiné à former une région de drain de transistor, de manière à réduire les blocs semi-conducteurs de liaison dans au moins une direction parallèle au plan principal du support et à former un ou plusieurs fils semi-conducteurs à base de Si_{1-y}Ge_{y}.
b) oxydation thermique d'au moins une partie de le couche semi-conductrice, de manière à former au moins une zone semi-conductrice à base de Si_{1-y}Ge_{y} comportant les blocs semi-conducteurs de liaison, le semi-conducteur des fils devenant à base de Si_{1-z}Ge_{z} (avec 0 < y < 1 et y < z).

La couche semi-conductrice à base de Si₁₋ₓGeₓ peut reposer sur une couche à base de Si.

Le support peut être un substrat SOI et la couche à base de Si peut appartenir audit substrat SOI et reposer sur une couche d'oxyde enterré du substrat SOI.

La couche semi-conductrice à base de Si₁₋ₓGeₓ peut être recouverte d'une autre couche à base de Si.

Selon une première possibilité, l'oxydation thermique d'au moins une partie de le couche semi-conductrice peut être une oxydation de toute la couche semi-conductrice.

Selon une variante, l'oxydation thermique d'au moins une partie de le couche semi-conductrice peut être une oxydation localisée de la couche semi-conductrice, réalisée à travers au moins une ouverture d'un masque à l'oxydation.

Selon une mise en oeuvre, entre l'étape a) et l'étape b), le procédé peut comprendre en outre l'étape de :
- gravure de la zone semi-conductrice à base de Si_{1-y}Ge_{y}, ou de la couche semi-conductrice, à travers un masquage, de manière à réaliser le ou les bloc (s) semi-conducteur (s) de liaison et le bloc semi-conducteur destiné à former la région de source de transistor et l'autre bloc semi-conducteur destiné à former une région de drain de transistor.

A l'étape d'oxydation thermique latérale des flancs d'un ou plusieurs blocs, le(s) bloc(s) semi-conducteur(s) de liaison, le bloc semi-conducteur destiné à former la région de source de transistor et l'autre bloc semi-conducteur destiné à former une région de drain de transistor peuvent être surmontés d'un masque à oxydation.

Selon une possibilité, le masque à oxydation peut recouvrir les flancs du bloc semi-conducteur destiné à former une région de source et du bloc semi-conducteur destiné à former une région de drain.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1E illustrent un premier exemple de procédé suivant l'invention de réalisation d'un dispositif microélectronique doté d'un ou plusieurs fils semi-conducteurs à base de Si_{1-z}Ge_{z} apte (s) à former une structure de canal de transistor,
- les figures 2A-2D et 3A-3B illustrent, respectivement selon une vue en coupe et selon une vue de dessus, une variante de procédé suivant l'invention de réalisation d'un dispositif microélectronique doté d'un ou plusieurs fils semi-conducteurs à base de Si_{1-z}Ge_{z} apte (s) à former une structure de canal de transistor.

Des parties identiques, similaires ou équivalentes des différentes figures peuvent porter les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

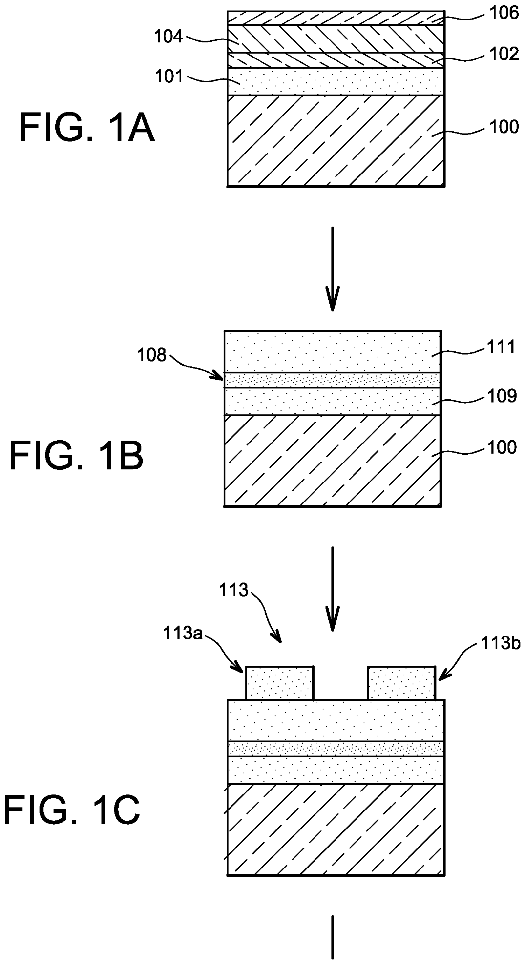

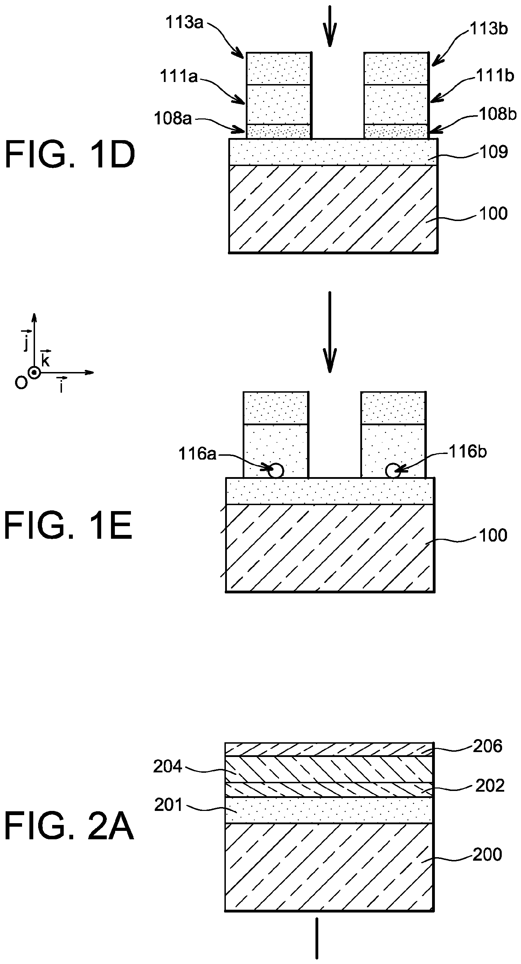

Un exemple de procédé, suivant l'invention, de réalisation d'un dispositif microélectronique doté d'un ou plusieurs fils semi-conducteurs à base de Si_{1-z}Ge_{z} (avec 0 < z ≤ 1), va à présent être donné en liaison avec les figures 1A à 1E.

Le matériau de départ du procédé peut être un substrat de type semi-conducteur sur isolant, par exemple de type SOI (SOI pour « silicon on insulator » ou silicium sur isolant) comprenant une couche de support 100 par exemple à base de Si, recouverte d'une couche de matériau diélectrique 101 par exemple une couche d'oxyde enterré (« burried oxyde » selon la terminologie anglo-saxonne) elle-même recouverte d'une fine couche semi-conductrice 102 qui peut être à base de Si, et d'épaisseur comprise par exemple entre 5 et 100 nanomètres ou par exemple de l'ordre de 20 nanomètres. Sur la première fine couche semi-conductrice 102, une autre couche semi-conductrice 104 à base de Si₁₋ₓGeₓ, avec 0 < x < y ≤ 1, avec x par exemple de l'ordre de 0,1 ou compris entre 0,01 et 0,5, est formée. La couche semi-conductrice 104 à base de Si₁₋ₓGeₓ peut être réalisée par exemple par épitaxie, et avoir une épaisseur inférieure à l'épaisseur critique de relaxation plastique, c'est-à-dire une couche à base de SiGe contraint, ou comprise par exemple entre 5 et 200 nm ou par exemple entre 10 et 75 nanomètres. Sur la couche semi-conductrice 104 à base de Si₁₋ₓGeₓ, une deuxième fine couche 106 à base de Si peut être réalisée. La deuxième fine couche 106 peut être par exemple d'épaisseur comprise entre 0 et 10 nm et formée par épitaxie (figure 1A).

Ensuite, on effectue une étape de condensation du germanium de la couche 104 semi-conductrice à base de Si₁₋ₓGeₓ, par exemple à l'aide d'un procédé d'oxydation tel que décrit dans le document : « A novel fabrication technique of ultrathin and relaxed SiGe buffer layers with high Ge fraction for sub-100 nm strained silicon on insulator MOSFETs, Tezuka et al., Japaneese Journal of Applied Physics, vol. 40, p 2866-2874, 2001 » ou dans le document « Selectively formed high mobility SiGe on Insulator pMOSFETs with Ge-rich strained surface channels using local condensation technique, Tezuka et al., Symposium on VLSI Technology, 2004 ». Pour effectuer cette condensation de Ge, au moins une première étape d'oxydation thermique de la couche semi-conductrice 104 à base de Si₁₋ₓGeₓ est réalisée à haute température. La température d'oxydation est de préférence inférieure à la température de fusion du matériau Si₁₋ₓGeₓ de la couche semi-conductrice 104. Une oxydation en plusieurs étapes et à des températures décroissantes entre les étapes peut éventuellement être réalisée. Dans cet exemple, l'oxydation est réalisée sur toute la couche semi-conductrice 104, sans faire appel à un masquage.

Durant l'étape d'oxydation, le silicium de la première fine couche semi-conductrice 102, de la deuxième fine couche semi-conductrice 106, et de la couche semi-conductrice 104 à base de Si₁₋ₓGeₓ, a tendance à se consommer, de manière à former du SiO₂. Le germanium de la couche semi-conductrice 104 à base de Si₁₋ₓGeₓ, est quant à lui très peu ou pas soluble dans le SiO₂. Une fois l'étape d'oxydation terminée, on obtient une couche 108 à base de Si_{1-y}Ge_{y} (avec y > x) enrichie en germanium, ayant une composition en germanium ou une teneur en germanium supérieure à celle de la couche semi-conductrice 104 à base de Si₁₋ₓGeₓ. La durée de l'étape d'oxydation peut avoir été adaptée en fonction de l'épaisseur et/ou de la concentration en germanium que l'on souhaite obtenir dans la couche 108 semi-conductrice à base de Si_{1-y}Ge_{y}. La couche 108 à base de Si_{1-y}Ge_{y}, peut avoir une composition en germanium telle que y est par exemple de l'ordre de 25 % ou par exemple comprise entre 8 et 50 % ; la taille (hauteur) du fil est également ici définie. Une fois l'étape d'oxydation terminée, la couche 108 à base de Si_{1-y}Ge_{y} est située entre deux couches isolantes à base de SiO₂. La couche 108 à base de Si_{1-y}Ge_{y} repose sur une première couche isolante 109 formée de la couche 101 d'oxyde enterré à base de SiO₂. La couche 108 à base de Si_{1-y}Ge_{y} est également surmontée d'une deuxième couche isolante 111 résultant de l'oxydation du silicium des couches semi-conductrices 106 et 104 (figure 1B).

Ensuite, un masquage 113 est réalisé sur la deuxième couche isolante 111. Avantageusement, la couche isolante 111 pourrait être retirée avant masquage, par voie humide (par exemple HF/H₂O).

Le masquage 113 est destiné à jouer le rôle de masque de gravure et de masque à oxydation de la couche semi-conductrice 108 à base de Si_{1-y}Ge_{y}. Le masquage 113 peut être par exemple à base d'un matériau diélectrique différent de celui de la deuxième couche isolante 111, par exemple du Si₃N₄. Le masquage 113 comporte plusieurs motifs, et notamment au moins un motif de source, au moins un motif de drain et un ou plusieurs motifs d'une structure reliant la source et le drain. Le masquage 113 peut comporter notamment deux motifs 113a, 113b (vus selon une coupe transversale sur la figure 1C) reliant les motifs de source et de drain. Le masquage 113 peut être formé à l'aide d'au moins une étape de photolithographie. La réalisation du masquage peut comprendre le dépôt d'une couche de résine photosensible, la définition de motifs dans cette couche de résine photosensible, puis la reproduction des motifs de la couche de résine dans une couche de matériau diélectrique, par exemple du Si₃N₄ déposée préalablement sur la deuxième couche isolante 111. La reproduction des motifs dans la couche diélectrique à base de Si₃N₄ peut être réalisée par gravure par voie sèche ou humide, par exemple à l'aide de H₃PO₄ ou d'un mélange CF₄/CH₃F. La couche de résine peut être ensuite retirée.

Puis, une ou plusieurs gravures, par exemple anisotropes, sont réalisées à travers le masquage 113, de manière à reproduire le dessin du masquage et notamment les motifs 113a, 113b dans la deuxième couche isolante 111 et dans la couche semi-conductrice 108 à base de Si_{1-y}Ge_{y}. La gravure de la couche isolante 111 peut être réalisée par exemple à l'aide d'un mélange CF₄/CH₂F₂, tandis que la gravure de la couche à base de Si_{1-y}Ge_{y} peut être réalisée par exemple à l'aide de HBr/O₂. La gravure de la couche semi-conductrice 108 est prévue de préférence avec un arrêt sur la première couche isolante 109. A la suite de la gravure de la couche 108 des blocs semi-conducteurs 108a, 108b dits « de liaison », à base de Si_{1-y}Ge_{y}, sont formés et surmontés respectivement de motifs 111a, 111b réalisés dans ladite deuxième couche isolante 111 (figure 1D).

Les blocs semi-conducteurs 108a, 108b de liaison à base de Si_{1-y}Ge_{y} relient chacun un bloc semi-conducteur à base de Si_{1-y}Ge_{y} destiné à former une région de source, et un autre bloc semi-conducteur à base de Si_{1-y}Ge_{y} destiné à former une région de drain.

Avantageusement, mais accessoirement, les flancs peuvent être protégés par un matériau diélectrique en fine couche, par exemple SiO₂ sur quelques nanomètres, par exemple entre 1 et 5 nm.

Puis, on effectue une autre étape de condensation Germanium des blocs sem-conducteurs 108a et 108b à base de Si_{1-y}Ge_{y}. Pour effectuer cette condensation de Ge, au moins une étape d'oxydation thermique des blocs semi-conducteurs 108a et 108b à base de Si_{1-y}Ge_{y} est réalisée à haute température. La condensation, ou oxydation, réalisée est une condensation latérale ou une oxydation latérale des blocs semi-conducteurs 108a, 108b, ces derniers étant surmontés par les motifs 111a, 111b de SiO₂ et 113a, 113b du masquage 113 à oxydation. La température d'oxydation est de préférence inférieure à la température de fusion du matériau Si_{1-y}Ge_{y} des blocs semi-conducteurs 108. Une oxydation en une ou plusieurs étapes et à des températures décroissantes peut être réalisée. Durant l'oxydation latérale, la largeur (définie dans une direction parallèle au vecteur *̅i̅*̅ d'un repère orthogonal [O;*i̅;j̅;k̅*]) des blocs semi-conducteurs 108a, 108b se réduit. L'étape d'oxydation est prolongée jusqu'à obtention en remplacement des blocs semi-conducteurs 108a, 108b, de fils semi-conducteurs 116a, 116b à base de Si_{1-z}Ge_{z} (avec z > y > x). Les fils 116a, 116b, ont une composition en Germanium ou une teneur en Germanium supérieure à celle des blocs semi-conducteurs 108a, 108b à base de Si_{1-y}Ge_{y}. Les fils 116a, 116b peuvent avoir une dimension critique ou une largeur (mesurées dans une direction parallèle au vecteur *̅i̅*̅ d'un repère orthogonal [O;*i̅;j̅*;*̅k̅*̅]) par exemple de l'ordre de 10 nm ou par exemple comprise entre 1 nanomètres et 100 nanomètres. La durée de l'étape d'oxydation latérale peut avoir été adaptée en fonction de l'épaisseur latérale et de la concentration en Germanium que l'on souhaite obtenir dans les fils 116a, 116b. Les fils 116a, 116b à base de Si_{1-z}Ge_{z}, peut avoir une composition en Germanium telle que z est par exemple compris entre 0,5 et 1. Les fils 116a, 116b obtenus après oxydation latérale sont entourés de matériau isolant SiO₂. Ces fils 116a, 116b sont destinés à former une structure de canal ou multicanaux d'un transistor, et relient une premier bloc semi-conducteur (non représenté) destiné à former une région de source du transistor et un autre bloc semi-conducteur (non représenté) destiné à former une région de drain du transistor.

Un amincissement du matériau isolant à base de SiO₂ peut être ensuite réalisé pour former un diélectrique de grille. Ensuite, des étapes de dépôt d'une couche de matériau de grille, par exemple du TiN et/ou du silicium polycristallin, puis de gravure de la couche de matériau de grille peuvent être réalisées afin de former une grille pour le transistor.

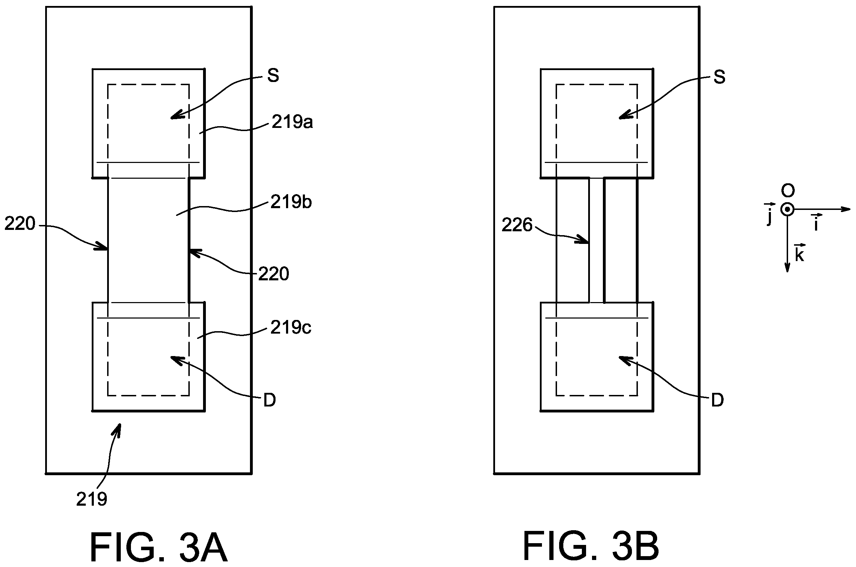

Une variante de l'exemple de procédé précédemment décrit, va à présent être donnée en liaison avec les figures 2A-2D et 3A-3B. Cette variante a pour but la réalisation d'un dispositif microélectronique doté d'un ou plusieurs fils semi-conducteurs à base de Si_{1-z}Ge_{z}, reliant une zone semi-conductrice de source et une zone semi-conductrice de drain à base d'un matériau semi-conducteur différent de celui des fils, ayant par exemple une concentration en germanium inférieure à celle desdits fils ou/et une concentration en silicium plus importante que celle desdits fils.

Le matériau de départ du procédé peut être un substrat semi-conducteur sur isolant, du type de celui de l'exemple de procédé précédemment décrit, comprenant une couche de support 200 par exemple à base de Si, recouverte d'une couche de matériau diélectrique 201 par exemple une couche d'oxyde enterré (« burried oxyde » selon la terminologie anglo-saxonne) recouverte d'une fine couche semi-conductrice 202 à base de Si, elle-même recouverte d'une couche semi-conductrice 204 à base de Si₁₋ₓGeₓ, avec 0 < x < y ≤ 1, par exemple avec x compris entre 0,05 et 0,5, ou de l'ordre de 0,1 ou de 0,3 et d'épaisseur comprise par exemple entre 5 et 200 nanomètres ou par exemple entre 40 et 75 nanomètres. Sur la couche semi-conductrice 204 à base de Si₁₋ₓGeₓ, une deuxième fine couche semi-conductrice 206 superficielle ou dite de « cap » à base de Si peut être également formée. La deuxième fine couche 206 peut être par exemple d'épaisseur comprise entre 0,5 nanomètres et plusieurs dizaines de nanomètres, par exemple de l'ordre de 2 nanomètres et réalisée par épitaxie (figure 2A).

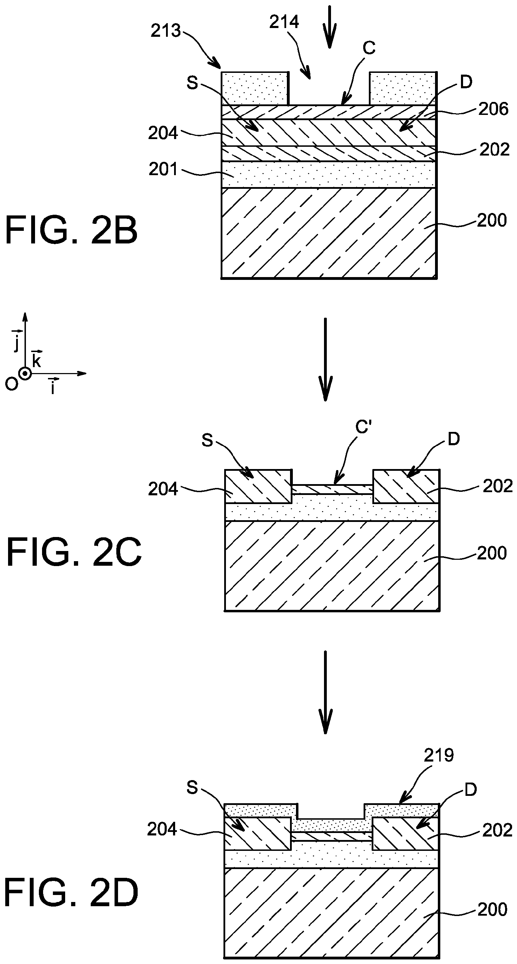

Ensuite, un premier masquage 213 est réalisé sur la fine couche semi-conductrice 206. Le premier masquage 213 est destiné à servir de masquage à oxydation, et est prévu pour bloquer ou ralentir une oxydation des parties des couches semi-conductrices 202, 204, 206 recouvertes par ce dernier, lors d'une étape de condensation germanium par oxydation thermique. Le premier masquage 213 peut être formé par exemple par dépôt d'une couche de matériau diélectrique, par exemple du Si₃N₄, puis par réalisation d'au moins une ouverture 214 dans cette couche de matériau diélectrique (figure 2B).

L'ouverture 214 dévoile un bloc semi-conducteur C dit « de liaison » comprenant une portion de la fine couche 202 à base de Si, recouverte par une portion de la couche 204 à base de Si₁₋ₓGeₓ, elle-même recouverte par une portion de la fine couche 206 à base de Si. Le bloc semi-conducteur C relie un bloc semi-conducteur S, dans lequel une région de source de transistor est destinée à être réalisée, et un autre bloc semi-conducteur D dans lequel une région de drain de transistor est destiné à être réalisé. On effectue ensuite une étape de condensation localisée du Ge de la couche semi-conductrice 204 à base de Si₁₋ₓGeₓ, et en particulier de la portion de la couche semi-conductrice 204 à base de Si₁₋ₓGeₓ appartenant au bloc semi-conducteur C.

Pour effectuer cette condensation de Ge, au moins une étape d'oxydation thermique localisée de la couche semi-conductrice 204 à base de Si₁₋ₓGeₓ est réalisée à haute température à travers l'ouverture 214. La température d'oxydation est de préférence inférieure à la température de fusion du matériau Si₁₋ₓGeₓ de la couche semi-conductrice 204. Une oxydation en une ou plusieurs étapes et à des températures décroissantes peut être réalisée. Durant l'étape d'oxydation, le silicium des portions des couches semi-conductrices 206, 204, 202 dévoilées par l'ouverture 214, a tendance à se consommer, de manière à former du SiO₂. Le germanium de la couche semi-conductrice 204 est quant à lui très peu ou pas soluble dans le SiO₂. Une fois l'étape d'oxydation terminée, on obtient un bloc semi-conducteur C' à base de Si_{1-y}Ge_{y} (avec y > x) dévoilé par l'ouverture 214 et ayant une composition en Germanium ou une teneur en Germanium supérieures à celles de la couche semi-conductrice 204 à base de Si₁₋ₓGeₓ. La composition après oxydation, des zones semi-conductrices situées sous le masquage 213 dépend de l'épaisseur et/ou de la composition choisie(s) pour ce masquage 213. Selon une possibilité, après oxydation, les zones semi-conductrices situées sous le masquage 213 et notamment les blocs semi-conducteurs S et D destinés à former respectivement une région de source et une région de drain peuvent avoir une composition identique ou proche de celle qu'elles avaient avant oxydation. Selon une autre possibilité, les blocs semi-conducteurs S et D situés sous le masquage 213 peuvent avoir subi une légère oxydation, tout en ayant une concentration en germanium inférieure à celle du bloc semi-conducteur C' à base de Si_{1-y}Ge_{y}.

La durée de l'étape d'oxydation peut avoir été adaptée en fonction de l'épaisseur et/ou de la concentration en Germanium que l'on souhaite obtenir dans le bloc semi-conducteur C' à base de Si_{1-y}Ge_{y}. Ensuite, une étape de désoxydation lors de laquelle on élimine les zones à base de SiO₂ résultant de l'oxydation du silicium des couches 204 et 206 peut être effectuée. La désoxydation peut être réalisée par exemple à l'aide d'une solution à base de HF dilué (figure 2C).

Ensuite, on dépose une couche de matériau diélectrique sur les couches semi-conductrices, par exemple du Si₃N₄, puis on définit, par gravure, jusqu'à la couche isolante 201 d'oxyde enterré des motifs d'un deuxième masquage 219 dans cette couche de matériau diélectrique (figure 2D). Le deuxième masquage 219 peut comporter au moins une partie 219a surmontant et recouvrant les flancs du bloc semi-conducteur S région de source de transistor, au moins une autre partie 219c surmontant et recouvrant les flancs du bloc semi-conducteur D région de drain de transistor et au moins un motif 219b surmontant le bloc semi-conducteur C' reliant la région de source et la région de drain, les flancs du bloc semi-conducteur C'. Le deuxième masquage est réalisé de sorte que les flancs 220 du bloc semi-conducteur C' à base de Si_{1-y}Ge_{y} sont dévoilés (figure 3A, le dispositif étant représenté en vue de dessus sur cette figure).

On effectue ensuite une deuxième étape de condensation de Germanium à travers le deuxième masquage 219. La condensation comporte au moins une étape d'oxydation thermique des flancs 220 du bloc semi-conducteur C' à base de Si_{1-y}Ge_{y}. Durant l'étape d'oxydation le silicium du bloc semi-conducteur C' à base de Si_{1-y}Ge_{y} a tendance à se consommer, de manière à former du SiO₂. Le germanium est quant à lui très peu ou pas soluble dans le SiO₂. L'oxydation latérale du bloc semi-conducteur C' à base de Si_{1-y}Ge_{y}, est prolongée jusqu'à obtenir à la place une zone semi-conductrice ou un fil semi-conducteur 226 à base de Si_{1-z}Ge_{z} (avec z > y > x) de composition en Germanium ou de teneur en Germanium supérieure à celle du bloc semi-conducteur C' à base de Si_{1-y}Ge_{y}. Le fil 226 a également une dimension critique ou une largeur (mesurée dans une direction parallèle au vecteur *̅i̅*̅ d'un repère orthogonal [O;*̅i̅*̅;*̅j̅*̅;*̅k̅*̅]) inférieure à celle du bloc semi-conducteur C'. Le fil 226 peut avoir une largeur ou une dimension critique par exemple de l'ordre de 10 nm ou par exemple comprise entre 1 nanomètres et 100 manomètres. La durée de l'étape d'oxydation latérale peut avoir été adaptée en fonction de l'épaisseur du fil et/ou de la concentration en Germanium que l'on souhaite obtenir dans le fil 226. Le fil 226 à base de Si_{1-z}Ge_{z}, peut avoir une composition en Germanium telle que z est par exemple de l'ordre de 1 (compris entre 0,5 et 1). Le fil 226 à base de Si_{1-z}Ge_{z}, relie un bloc semi-conducteur S destiné à former une région de source de transistor et un bloc semi-conducteur D destiné à former une région de drain de transistor, ayant chacun une concentration en germanium inférieure à celle du fil 226.

Il est également possible qu'un dispositif microélectronique doté d'un ou plusieurs fils semi-conducteurs à base de Si_{1-z}Ge_{z} (avec 0 < z ≤ 1) puisse être obtenu en réalisant tout d'abord une oxydation thermique latérale des flancs, puis une oxydation thermique d'au moins une partie de la couche semi-conductrice, ces étapes pouvant être réalisées de manière analogue aux exemples décrit précédemment.

## Revendications

1. Procédé de réalisation d'un dispositif microélectronique comportant un ou plusieurs fils semi-conducteurs à base de Si_{1-z}Ge_{z}, avec 0 < z ≤ 1, comprenant les étapes de :
a) oxydation thermique d'au moins une partie d'une couche semi-conductrice (104, 204) à base de Si₁₋ₓGeₓ, avec 0 < x < 1, reposant sur un substrat de type semiconducteur sur isolant, de manière à former au moins une zone semi-conductrice (C) à base de Si_{1-y}Ge_{y} avec 0 < y < 1 et x < y;
b) oxydation thermique latérale des flancs d'un ou plusieurs blocs (108a, 108b, C') semi-conducteurs dits « de liaison » issus de ladite zone semi-conductrice à base de Si_{1-y}Ge_{y} et reliant un bloc (S) semi-conducteur destiné à former une région de source de transistor et un autre bloc (D) destiné à former une région de drain de transistor, de manière à réduire les blocs (108a, 108b, C') semi-conducteurs de liaison dans au moins une direction parallèle au plan principal du support et à former un ou plusieurs fils (116a, 116b, 226) semi-conducteurs à base de Si_{1-z}Ge_{z} avec 0 < y < 1 et y < z.
ou
a) oxydation thermique latérale des flancs d'un ou plusieurs blocs (108a, 108b, C') semi-conducteurs dits « de liaison » issus d'une couche semi-conductrice (104, 204) à base de Si₁₋ₓGeₓ, avec 0 < x < 1, reposant sur un substrat de type semiconducteur sur isolant et reliant un bloc (S) semi-conducteur destiné à former une région de source de transistor et un autre bloc (D) destiné à former une région de drain de transistor, de manière à réduire les blocs (108a, 108b, C') semi-conducteurs de liaison dans au moins une direction parallèle au plan principal du support et à former des blocs semi-conducteurs de liaison à base de Si_{1-y}Ge_{y} avec 0 < y < 1 et x < y;
b) oxydation thermique d'au moins une partie de la couche semi-conductrice (104, 204), de manière mettre les blocs semi-conducteurs de liaison sous forme de fils (116a, 116b, 226) à base de Si_{1-z}Ge_{z} avec 0 < y < 1 et y < z.

2. Procédé selon la revendication 1, la couche (104, 204) semi-conductrice à base de Si₁₋ₓGeₓ reposant sur une couche (102,202) à base de Si.

3. Procédé selon la revendication 2, dans lequel le support est un substrat SOI et dans lequel la couche (102, 202) à base de Si appartient audit substrat SOI et ladite couche isolante (102) est une couche d'oxyde enterré du substrat SOI.

4. Procédé selon l'une des revendications 1 à 3, la couche semi-conductrice à base de Si₁₋ₓGeₓ étant recouverte d'une autre couche (106, 206) à base de Si.

5. Procédé selon l'une des revendications 1 à 4, dans lequel l'oxydation thermique d'au moins une partie de la couche semi-conductrice (104) est une oxydation de toute la couche semi-conductrice (104).

6. Procédé selon l'une des revendications 1 à 5, dans lequel l'oxydation thermique d'au moins une partie de le couche semi-conductrice (204) est une oxydation localisée de la couche semi-conductrice (204), réalisée à travers au moins une ouverture (214) d'un masque (213) à l'oxydation.

7. Procédé selon l'une des revendications 1 à 6, dans lequel entre l'étape a) et l'étape b), le procédé comprend en outre l'étape de :
- gravure de la couche semi-conductrice (104, 204) à travers un masquage, de manière à réaliser le ou les bloc(s) semi-conducteur(s) (108a, 108b, C') de liaison et le bloc semi-conducteur destiné à former la région de source de transistor et l'autre bloc semi-conducteur destiné à former une région de drain de transistor.

8. Procédé selon l'une des revendications 1 à 7, dans lequel lors de l'étape d'oxydation thermique latérale des flancs d'un ou plusieurs blocs (108a, 108b, C'), le ou les bloc(s) semi-conducteur(s) de liaison, le bloc semi-conducteur (S) destiné à former la région de source de transistor et l'autre bloc semi-conducteur (D) destiné à former une région de drain de transistor sont surmontés d'un masque (113,219) à l'oxydation.

9. Procédé selon la revendication 8, le masque à oxydation recouvrant les flancs du bloc semi-conducteur destiné à former une région de source et du bloc semi-conducteur destiné à former une région de drain.

## Patentansprüche

1. Verfahren zur Herstellung einer mikroelektronischen Vorrichtung, die einen oder mehrere Halbleiterdrähte auf Basis von Si_{1-z}Ge_{z} mit 0 < z ≤ 1 umfasst, umfassend die folgenden Schritte:
a) thermische Oxidation wenigstens eines Teils einer Halbleiterschicht (104,204) auf Basis von Si₁₋ₓGeₓ mit 0 < x < 1, die auf einem Substrat ruht, vom Typ Halbleiter auf Substrat, derart, dass wenigstens eine Halbleiterzone (C) auf Basis von Si_{1-y}Ge_{y} mit 0 < y < 1 und x < y gebildet wird;
b) laterale thermische Oxidation der Flanken eines oder mehrerer sogenannter "Verbindungs-"Halbleiterblöcke (108a, 108b, C'), die aus der Halbleiterzone auf Basis von Si_{1-y}Ge_{y} hervorgehen und einen Halbleiterblock (S), der dazu ausgelegt ist, eine Transistor-Source-Region zu bilden, und einen anderen Block (D)verbinden, der dazu ausgelegt ist, eine Transistor-Drain-Region zu bilden, derart, dass die Verbindungs-Halbleiterblöcke (108a, 108b, C') in wenigstens einer Richtung parallel zur Hauptebene des Trägers reduziert werden und ein oder mehrere Halbleiterdrähte (116a, 116b, 226) auf Basis von Si_{1-z}Ge_{z} mit 0 < y < 1 und y < z gebildet werden,
oder
a) laterale thermische Oxidation der Flanken eines oder mehrerer sogenannter "Verbindungs-"Halbleiterblöcke (108a, 108b, C'), die aus einer Halbleiterschicht (104, 204) auf Basis von Si₁₋ₓGeₓ mit 0 < x < 1 hervorgehen, die auf einem Substrat ruht, vom Typ Halbleiter auf Substrat, und einen Halbleiterblock (S), der dazu ausgelegt ist, eine Transistor-Source-Region zu bilden, und einen anderen Block (D) verbinden, der dazu ausgelegt ist, eine Transistor-Drain-Region zu bilden, derart, dass die Verbindungs-Halbleiterblöcke (108a, 108b, C') in wenigstens einer Richtung parallel zur Hauptebene des Trägers reduziert werden und Verbindungs-Halbleiterblöcke auf Basis von Si_{1-y}Ge_{y} mit 0 < y < 1 und x < y gebildet werden;
b) thermische Oxidation wenigstens eines Teils der Halbleiterschicht (104, 204) derart, dass die Verbindungs-Halbleiterblöcke in die Form von Drähten (116a, 116b, 226) auf Basis von Si_{1-z}Ge_{z} mit 0 < y < 1 und y < z gebracht werden.

2. Verfahren nach Anspruch 1, wobei die Halbleiterschicht (104, 204) auf Basis von Si₁₋ₓGeₓ auf einer Schicht (102, 202) auf Basis von Si ruht.

3. Verfahren nach Anspruch 2, wobei der Träger ein SOI-Substrat ist, und wobei die Schicht (102, 202) auf Basis von Si zu dem SOI-Substrat gehört, und die isolierende Schicht (102) eine vergrabene Oxidschicht des SOI-Substrats ist.

4. Verfahren nach einem der Ansprüche 1 bis 3, wobei die Halbleiterschicht auf Basis von Si₁₋ₓGeₓ mit einer anderen Schicht (106, 206) auf Basis von Si bedeckt ist.

5. Verfahren nach einem der Ansprüche 1 bis 4, wobei die thermische Oxidation wenigstens eines Teils der Halbleiterschicht (104) eine Oxidation der gesamten Halbleiterschicht (104) ist.

6. Verfahren nach einem der Ansprüche 1 bis 5, wobei die thermische Oxidation wenigstens eines Teils der Halbleiterschicht (204) eine lokalisierte Oxidation der Halbleiterschicht (204) ist, die durch wenigstens eine Öffnung (214) einer Oxidationsmaske (213) realisiert wird.

7. Verfahren nach einem der Ansprüche 1 bis 6, wobei das Verfahren zwischen dem Schritt a) und dem Schritt b) ferner folgenden Schritt umfasst:
- Gravieren der Halbleiterschicht (104, 204) durch eine Maskierung hindurch, derart, dass der oder die Verbindungs-Halbleiterblock/Halbleiterblöcke (108a, 108b, C') und der Halbleiterblock realisiert werden, der dazu ausgelegt ist, die Transistor-Source-Region zu bilden, sowie der andere Halbleiterblock, der dazu ausgelegt ist, eine Transistor-Drain-Region zu bilden.

8. Verfahren nach einem der Ansprüche 1 bis 7, wobei während des Schritts der lateralen thermischen Oxidation der Flanken eines oder mehrerer Blöcke (108a, 108b, C') der oder die Verbindungs-Halbleiterblöck/Halbleiterblöcke, der Halbleiterblock (S), der dazu ausgelegt ist, die Transistor-Source-Region zu bilden, sowie der andere Halbleiterblock (D), der dazu ausgelegt ist, eine Transistor-Drain-Region zu bilden, von einer Oxidationsmaskierung (113, 219) überlagert sind.

9. Verfahren nach Anspruch 8, wobei die Oxidationsmaske die Flanken des Halbleiterblocks bedeckt, der dazu ausgelegt ist, eine Source-Region zu bilden, sowie des Halbleiterblocks, der dazu ausgelegt ist, eine Drain-Region zu bilden.

## Claims

1. A method for producing a microelectronic device, comprising one or more Si_{1-z}Ge_{z} based semiconductor wire(s) (with 0 < z ≤ 1), said method including the steps of:
a) thermal oxidation of at least a portion of a Si₁₋ₓGeₓ-based semiconductor layer (104, 204) (with 0 < x < 1) resting on a semi-conductor on insulator type substrate, so as to form at least one Si_{1-y}Ge_{y} based semiconductor zone (with 0 < y < 1 and x < y),
b) lateral thermal oxidation of the sides of one or more so-called semiconductor "connection" blocks (108a, 108b, C') from said Si_{1-y}Ge_{y}-based semiconductor zone and connecting a semiconductor block (S) intended to form a transistor source region and another block (D) intended to form a transistor drain region so as to reduce the semiconductor connection blocks (108a, 108b, C') in at least one direction parallel to the main plane of the support and to form one or more Si_{1-z}Ge_{z}-based semiconductor wire(s) (116a, 116b, 226) (with 0 < y < 1 and y < z) or
a) lateral thermal oxidation of the sides of one or more semiconductor "connection" blocks (108a, 108b, C') of a Si₁₋ₓGeₓ-based semiconductor layer (104, 204) (with 0 < x < 1) resting on a semi-conductor on insulator type substrate and connecting a semiconductor block (S) intended to form a transistor source region and another block (D) intended to form a transistor drain region so as to reduce the semiconductor connection blocks (108a, 108b, C') in at least one direction parallel to the main plane of the support and to form one or more Si_{1-y}Ge_{y} based semiconductor wire (s) (with 0 < y < 1 and x < y),
b) thermal oxidation of at least a portion of the semiconductor layer (104, 204), so as to form the semi-conductor blocks into Si_{1-z}Ge_{z} based wires (with 0 < y < 1 et y < z).

2. Method according to claim 1, **characterised in that** the Si₁₋ₓGeₓ-based semiconductor layer (104,204) rests on a Si-based layer.

3. Method according to claim 2, **characterised in that** the support is a SOI substrate and the Si-based layer belongs to said SOI substrate and rests on a buried oxide layer (102) of the SOI substrate.

4. Method according to any of the claims 1 to 3, the Si₁₋ₓGeₓ-based semiconductor layer being covered with another Si-based layer.

5. Method according to any of the claims 1 to 4, wherein the thermal oxidation of at least a portion of the semiconductor layer (104) is an oxidation of the entire semiconductor layer (104).

6. Method according to any of the claims 1 to 5, **characterised in that** the thermal oxidation of at least a portion of the semiconductor layer (204) is a localised oxidation of the semiconductor layer (204), performed through at least one opening (214) of an oxidation mask (213).

7. Method according to any of the claims 1 to 6, **characterised in that**, between step a) and step b), the method also includes the step of:
- etching the semiconductor layer (104, 204), through a mask, so as to produce the semiconductor connection block(s) (108a, 108b, C') and the semiconductor block intended to form the transistor source region and the other semiconductor block intended to form a transistor drain region.

8. Method according to any of the claims 1 to 7, **characterised in that**, in the step of lateral thermal oxidation of the sides of one or more block (s) (108a, 108b, C') semiconductor connection block(s), the semiconductor block (S) intended to form the transistor source region and the other semiconductor block (D) intended to form a transistor drain region are superimposed by an oxidation mask (113, 219).

9. Method according to claim 8, **characterised in that** the oxidation mask covers the sides of the semiconductor block intended to form a source region and the semiconductor block intended to form a drain region.
